# EUROPEAN PATENT APPLICATION

(11) **EP 2 043 147 A2**
(43) Date of publication of application: **01.04.2009**
(21) Application number: 08016796.8
(22) Date of filing: 24.09.2008
(51) Int. Cl.: H01L 23/26

(54) **Automotive electric/electronic package**

(30) Priority: 28.09.2007 JP 2007253828
(71) Applicant: Shin-Etsu Chemical Co., Ltd., Chiyoda-ku, Tokyo (JP)
(72) Inventor: Fukuda, Kenichi, Annaka-shi Gunma-ken (JP); Shiono, Mikio, Annaka-shi Gunma-ken (JP)
(74) Representative: Merkle, Gebhard

(57) **Abstract**

In an automotive electric/electronic package comprising an electronic component, a case for receiving the electronic component therein, and a lid covering an open top of the case, the case and the lid are joined together with a fluorochemical adhesive capable of chemically and/or physically adsorbing a corrosive gas. The package has highly reliable corrosion resistance in that the electronic component is protected from corrosion by corrosive acidic or basic gases such as sulfur compound and nitrogen oxide gases.

## Description

### TECHNICAL FIELD

This invention relates to automotive electric/electronic packages. Typical automotive electric/electronic packages are sensors installed in the engine compartment and comprising sensing elements for detecting various physical quantities, an electronic circuit for controlling the sensing elements, and output elements for delivering electrical signals corresponding to the physical quantities, and control units comprising a microprocessor for controlling various states in the vehicle in response to the electrical signals from the sensors.

### BACKGROUND ART

In the prior art, automotive electric/electronic packages are typically used in the encapsulated structure and implemented as physical detectors and controllers mounted in engine compartments as typified by the thermal air flow meter shown in JP-A 6-11373. These packages include cases, lids and other members which are often joined together with such adhesives as epoxy adhesives or silicone adhesives.

If such prior art packages in which members are bonded or sealed with silicone adhesives are placed in a corrosive gas atmosphere, the corrosive gas can penetrate through the silicone adhesive bonds or seals into the interior.

One proposal addressing this problem is by blending a metal powder in a silicone resin for adsorbing corrosive gases as disclosed in JP-A 2003-96301. This silicone resin composition is effective for adsorbing corrosive gases, but can be swollen or degraded by gasoline, engine oil or the like to which it is often exposed when mounted on vehicles. The composition is thus unsuited for use in the corrosive gas atmosphere.

Also, perfluoropolyether rubber compositions are known as the material resistant to gasoline, engine oil or the like. They are more effective than the silicone resins in preventing or retarding corrosion by acidic gases and sulfur-containing gases, but still cannot tolerate such exposure over a long term.

### DISCLOSURE OF THE INVENTION

An object of the invention is to provide an automotive electric/electronic package having an electronic component received therein, which package is reliable in corrosion resistance. That is, the package is adapted to protect the electronic component from corrosion by corrosive acidic or basic gases such as sulfur compound and nitrogen oxide gases.

The inventor has found that when a fluorochemical adhesive or encapsulant capable of chemically and/or physically adsorbing a corrosive gas is used as the adhesive or encapsulant in an automotive electric/electronic package, the resulting electric/electronic package is protected with the fluorochemical adhesive or encapsulant having solvent resistance, chemical resistance and minimal permeability of acidic gases or sulfur-containing gases. This protects any electronic component received in the package from corrosion by corrosive acidic or basic gases such as sulfur compound and nitrogen oxide gases. Then the electric/electronic package to be mounted on vehicles remains reliable with respect to corrosion resistance.

A first embodiment of the invention is an automotive electric/electronic package comprising an electronic component capable of functioning on application of electricity (such as a circuit board having electronic chips mounted thereon), a case for receiving the electronic component therein and having an open top, and a lid covering the open top of the case, wherein the case and the lid are joined together with a fluorochemical adhesive capable of chemically and/or physically adsorbing a corrosive gas.

A second embodiment of the invention is an automotive electric/electronic package comprising an electronic component capable of functioning on application of electricity (such as a circuit board having electronic chips mounted thereon), a base to which the electronic component is fixedly secured, a case surrounding the electronic component and having an open top, and a lid covering the open top of the case, wherein the case and the base and/or the case and the lid are joined together with a fluorochemical adhesive capable of chemically and/or physically adsorbing a corrosive gas.

A third embodiment of the invention is an automotive electric/electronic package comprising an electronic component capable of functioning on application of electricity (such as a circuit board having electronic chips mounted thereon), a base to which the electronic component is fixedly secured, a case surrounding the electronic component and having an open top, and optionally, a lid covering the open top of the case, wherein the electronic component is encapsulated with a fluorochemical encapsulant capable of chemically and/or physically adsorbing a corrosive gas. Optionally, the case and the base and/or the case and the lid are joined together with a fluorochemical adhesive capable of chemically and/or physically adsorbing a corrosive gas.

In a preferred embodiment, the fluorochemical adhesive is a curable perfluoropolyether rubber composition comprising
(A) 100 parts by weight of a linear perfluoropolyether compound containing at least two alkenyl radicals per molecule and having in its backbone a perfluoropolyether structure containing recurring units -CₐF₂ₐO- wherein a is an integer of 1 to 6,
(B) a curing amount of an organosilicon compound containing at least two silicon-bonded hydrogen atoms per molecule,
(C) 0.1 to 50 parts by weight of an inorganic powder capable of chemically and/or physically adsorbing an acidic gas and/or sulfur-containing gas, and
(D) a catalytic amount of a hydrosilylation catalyst.

In another preferred embodiment, the fluorochemical encapsulant is a curable perfluoropolyether gel composition comprising
(A) 25 to 65 parts by weight of a linear perfluoropolyether compound containing at least two alkenyl radicals per molecule and having in its backbone a perfluoropolyether structure containing recurring units -CₐF₂ₐO- wherein a is an integer of 1 to 6,
(B) a curing amount of an organosilicon compound containing at least two silicon-bonded hydrogen atoms per molecule,
(C) 0.1 to 50 parts by weight of an inorganic powder capable of chemically and/or physically adsorbing an acidic gas and/or sulfur-containing gas,
(D) a catalytic amount of a hydrosilylation catalyst, and
(E) 75 to 35 parts by weight of a polyfluoromonoalkenyl compound containing one alkenyl radical per molecule and having a perfluoropolyether structure in its backbone, with the proviso that the total amount of components (A) and (E) is 100 parts by weight.

The preferred component (C) in the perfluoropolyether composition is a metallic powder, a powdered active carbon or a powdered compound having hydrotalcite structure.

### BENEFITS OF THE INVENTION

In the automotive electric/electronic package of the invention, the fluorochemical adhesive or encapsulant protects any electronic component, typically a hybrid IC board, received in the package from corrosion by corrosive acidic or basic gases such as sulfur compound and nitrogen oxide gases. The electric/electronic package remains reliable with respect to corrosion resistance.

### BRIEF DESCRIPTION OF THE DRAWINGS

FIG. 1 is a schematic cross-sectional view of an automotive electric/electronic package in one embodiment of the invention.
FIG. 2 is a schematic cross-sectional view of an automotive electric/electronic package in another embodiment of the invention.
FIG. 3 is a schematic cross-sectional view of an automotive electric/electronic package in a further embodiment of the invention.

### DESCRIPTION OF THE PREFERRED EMBODIMENT

As used herein, the terms "top" and "bottom" are words of convenience and are not to be construed as limiting terms.

The term "automotive electric/electronic package" refers to an electric or electronic part to be mounted on automobiles or vehicles.

The automotive electric/electronic package of the invention comprises in one embodiment, an electronic component capable of functioning on application of electricity (such as a circuit board having electronic chips mounted thereon), a case for receiving the electronic component therein and having an open top, and optionally, a lid covering the open top of the case; or in another embodiment, an electronic component capable of functioning on application of electricity (such as a circuit board having electronic chips mounted thereon), a base to which the electronic component is fixedly secured, a case surrounding the electronic component and having an open top, and optionally, a lid covering the open top of the case.

The invention is characterized in that the case and the base and/or the case and the lid are joined together with a fluorochemical adhesive capable of chemically and/or physically adsorbing a corrosive gas; or the electronic component is encapsulated with a fluorochemical encapsulant capable of chemically and/or physically adsorbing a corrosive gas.

More specifically, the automotive electric/electronic package is protected with the fluorochemical adhesive and/or encapsulant having a minimal permeability of corrosive gases such as acidic gases and sulfur-containing gases. The package effectively prevents the electronic component from corrosion since corrosive acidic gases such as corrosive sulfur gas, sulfur compound gases, nitrogen oxide gases and COx gases, chlorine compound gases, and basic gases do not penetrate into the interior of the package.

Examples of the automotive electric/electronic package contemplated herein include, but are not limited to, gas pressure sensors, liquid pressure sensors, temperature sensors, humidity sensors, rotation sensors, gravity sensors, timing sensors, air flow meters, electronic circuits, semiconductor modules, and various control units. The sensors are to detect physical quantities including intake air flow rate, air temperature, ambient air pressure, boost pressure, fuel pressure and exhaust pressure. The semiconductor modules and control units receive signals from the sensors and function to control the combustion state within cylinders or control ATF systems.

Some embodiments of the invention are described below for illustrating the invention. The invention is by no means limited by the following description.

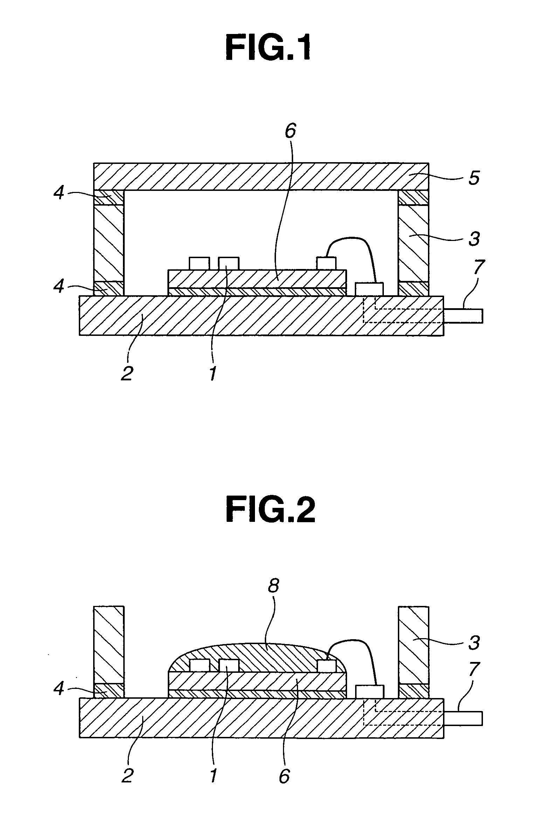

FIGS. 1 to 3 illustrate typical cross-sectional structures of the automotive electric/electronic package of the invention.

In FIG. 1, a planar substrate 6 having an electronic drive or control circuit 1 mounted thereon is adhesively secured to a metal or plastic base 2. A case 3 having open top and bottom is secured to the base 2 so as to receive the substrate 6 therein, with a fluorochemical adhesive 4 capable of chemically and/or physically adsorbing a corrosive gas. A lid 5 is secured to the case 3 with the adhesive 4 so as to close the open top.

The electronic drive or control circuit 1 on substrate 6 is typically a hybrid IC board in which capacitors, diodes, and semiconductor integrated circuit dies are mounted on a surface of a planar substrate 6 made of an inorganic material such as a ceramic, on which conductor wirings (serving as circuit interconnections) and resistors are printed and baked.

The case 3 for receiving the hybrid IC board therein, lid 5 covering the top of case 3, and base 2 are usually formed as an integral unit together with a connector providing an input/output signal interface of electronic drive circuit 1. A buried structure prepared by molding a resin compound over a terminal 7 (in the form of a conductive member for conduction of electrical signals) by an insert molding technique is often employed.

FIG. 2 illustrates an automotive electric/electronic package similar to that of FIG. 1. In this embodiment, the lid 5 is omitted, and a hybrid IC substrate is encapsulated with a fluorochemical encapsulant 8 capable of chemically and/or physically adsorbing a corrosive gas.

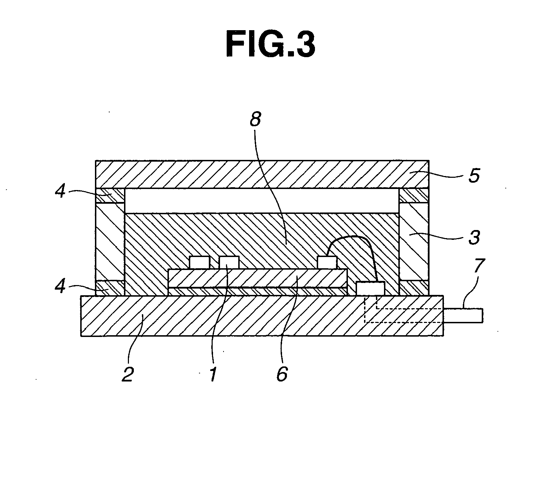

FIG. 3 illustrates an automotive electric/electronic package similar to that of FIG. 1. In this embodiment, the interior of the package is filled or encapsulated with a fluorochemical encapsulant 8 capable of chemically and/or physically adsorbing a corrosive gas.

The resins of which base 2, case 3 and lid 5 are formed are typically injection moldable resins including polybutylene terephthalate (PBT), polyphenylene sulfide (PPS), nylon 6, and nylon 66.

Since the automotive electric/electronic package is to be mounted within the engine compartment of a vehicle or automobile, it is exposed to the atmospheres of blow-back of engine combustion gases, feedback of unburned gases, stagnation of hydrocarbons, and exhaust gases. In addition, sulfur-rich rubber hoses commonly used in engine components are gathered in the engine compartment. It is thus desired that reliability be improved by an automotive electric/electronic package which is resistant against corrosive acidic gases such as corrosive sulfur compound and nitrogen oxide gases, and basic gases. In the automotive electric/electronic package, conductor wirings formed on an electronic drive circuit-carrying ceramic substrate are often formed of silver, copper or alloys thereof. If such conductor wirings are exposed to corrosive gases, they are disconnected by sulfide corrosion or the like so that the electronic drive circuit performs no longer.

Under the circumstances, it is necessary to prevent sulfide corrosion or the like. This is achievable using the fluorochemical adhesive 4 or encapsulant 8 capable of chemically and/or physically adsorbing a corrosive gas. A useful example of the fluorochemical adhesive or encapsulant capable of chemically and/or physically adsorbing a corrosive gas is the perfluoropolyether composition described in JP-A 2006-249416 (US 20060183859 A1, EP 1693398 B1). It is estimated that better results are obtained by incorporating a metallic powder, a powdered active carbon or a powdered hydrotalcite structure compound in the perfluoropolyether composition.

Specifically the fluorochemical adhesive capable of chemically and/or physically adsorbing a corrosive gas is preferably a curable perfluoropolyether rubber composition comprising
(A) a linear perfluoropolyether compound containing at least two alkenyl radicals per molecule and having in its backbone a perfluoropolyether structure containing recurring units -CₐF₂ₐO- wherein a is an integer of 1 to 6,
(B) an organosilicon compound containing at least two silicon-bonded hydrogen atoms per molecule,
(C) an inorganic powder capable of chemically and/or physically adsorbing an acidic gas and/or sulfur-containing gas, and
(D) a hydrosilylation catalyst.

Also, the fluorochemical encapsulant capable of chemically and/or physically adsorbing a corrosive gas is preferably a curable perfluoropolyether gel composition comprising
(A) a linear perfluoropolyether compound containing at least two alkenyl radicals per molecule and having in its backbone a perfluoropolyether structure containing recurring units -CₐF₂ₐO- wherein a is an integer of 1 to 6,
(B) an organosilicon compound containing at least two silicon-bonded hydrogen atoms per molecule,
(C) an inorganic powder capable of chemically and/or physically adsorbing an acidic gas and/or sulfur-containing gas,
(D) a hydrosilylation catalyst, and
(E) a polyfluoromonoalkenyl compound containing one alkenyl radical per molecule and having a perfluoropolyether structure in its backbone.

The components of the compositions are described in detail.

### Component A

Component (A) of the curable perfluoropolyether compositions according to the invention is a linear perfluoropolyether compound containing at least two alkenyl radicals per molecule and having a perfluoropolyether structure, preferably divalent perfluoroalkylether structure, in its backbone.

The perfluoroalkyl ether structures include structures comprising a plurality of recurring units -CₐF₂ₐO- wherein "a" is at each occurrence an integer of 1 to 6, for example, structures represented by the general formula (5):

(CₐF₂ₐO)_{q} (5)

wherein q is an integer of 50 to 600, preferably 50 to 400, and more preferably 50 to 200.

Examples of the recurring units -CₐF₂ₐO- are:
-CF₂O-, -CF₂CF₂O-, -CF₂CF₂CF₂O-, -CF(CF₃)CF₂O-,
-CF₂CF₂CF₂CF₂O-, -CF₂CF₂CF₂CF₂CF₂CF₂O-, and -C(CF₃)₂O-.

Of these, -CF₂O-, -CF₂CF₂O-, -CF₂CF₂CF₂O-, and -CF(CF₃)CF₂O- are preferred. It is understood that the perfluoroalkyl ether structure may consist of recurring units -CₐF₂ₐO- of one type or recurring units of two or more types.

The alkenyl radicals in the linear perfluoropolyether compound (A) are preferably those radicals having 2 to 8 carbon atoms, especially 2 to 6 carbon atoms, and terminated with a CH₂=CH- structure, for example, vinyl, allyl, propenyl, isopropenyl, butenyl, and hexenyl. Of these, vinyl and allyl are preferred. The alkenyl radicals may be attached to the backbone of linear perfluoropolyether compound at both ends either directly or through divalent linkages such as -CH₂-, -CH₂O- or -Y-NR-CO-. Herein Y is -CH₂- or a dimethylphenylsilylene radical of the formula (Z): 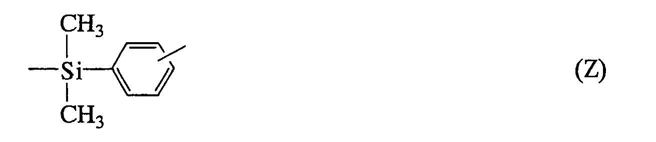 (inclusive of o-, m- and p-positions), and R is hydrogen, methyl, phenyl or allyl. There should be included at least two alkenyl radicals per molecule.

Suitable perfluoropolyether compounds (A) include polyfluorodialkenyl compounds of the general formulae (6) and (7).

CH₂=CH-(X)ₚ-Rf²-(X')ₚ-CH=CH₂ (6)

CH₂=CH-(X)ₚ-Q-Rf²-Q-(X')ₚ-CH=CH₂ (7)

Herein, X is independently -CH₂-, -CH₂O-, -CH₂OCH₂-or -Y-NR¹-CO- wherein Y is -CH₂- or a dimethylphenylsilylene radical of the structural formula (Z) and R¹ is hydrogen, methyl, phenyl or allyl. X' is -CH₂-, -OCH₂-, -CH₂OCH₂-or -CO-NR²-Y'- wherein Y' is -CH₂- or a dimethylphenylsilylene radical of the structural formula (Z') and R² is hydrogen, methyl, phenyl or allyl. 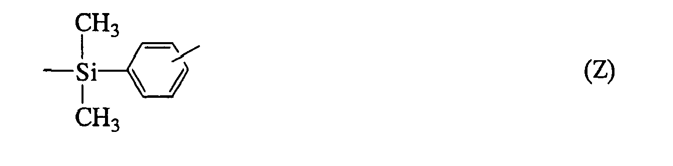 (inclusive of o-, m- and p-positions) 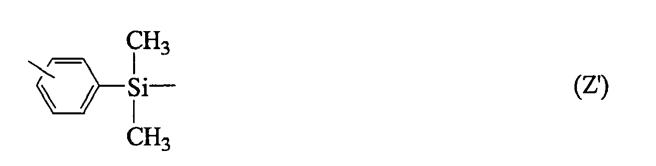 (inclusive of o-, m- and p-positions)

Rf² is a divalent perfluoropolyether structure, and preferably of the formula (5): (CₐF₂ₐO)_{q}. Q is a divalent hydrocarbon radical having 1 to 15 carbon atoms which may contain an ether bond, for example, an alkylene radical or an alkylene radical containing an ether bond. The letter p is independently 0 or 1.

The linear perfluoropolyether compound serving as component (A) is most preferably a compound of the general formula (1). 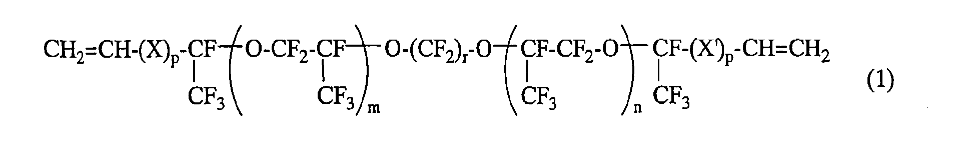 Herein, X, X' and p are as defined above, r is an integer of 2 to 6, each of m and n is an integer of 0 to 600, and the sum of m+n is 50 to 600.

The linear perfluoropolyether compound of formula (1) should desirably have a weight-average molecular weight (Mw) of 10,000 to 100,000, and most preferably 10,000 to 50,000 as determined by gel permeation chromatography (GPC) versus polyethylene standards. Compounds with Mw of less than 10,000 undergo substantial swell in gasoline and other solvents, as demonstrated by a swell factor of at least 6% in gasoline, failing to meet the requirements of parts that must be gasoline resistant. Compounds with Mw of more than 100,000 are too viscous to work, detracting from practical utility.

Illustrative examples of the linear perfluoropolyether compound of formula (1) are given below. 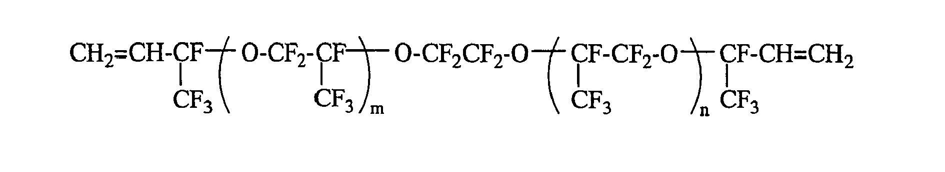 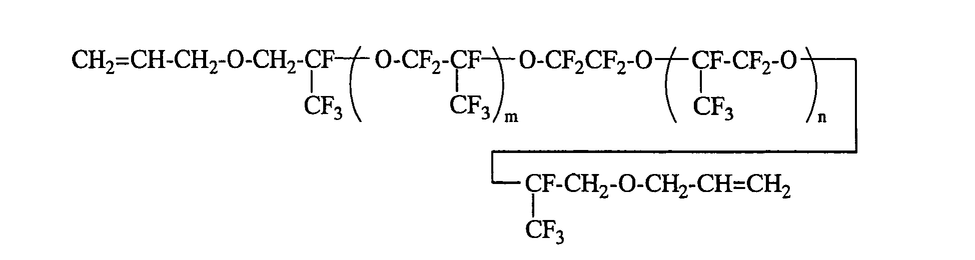 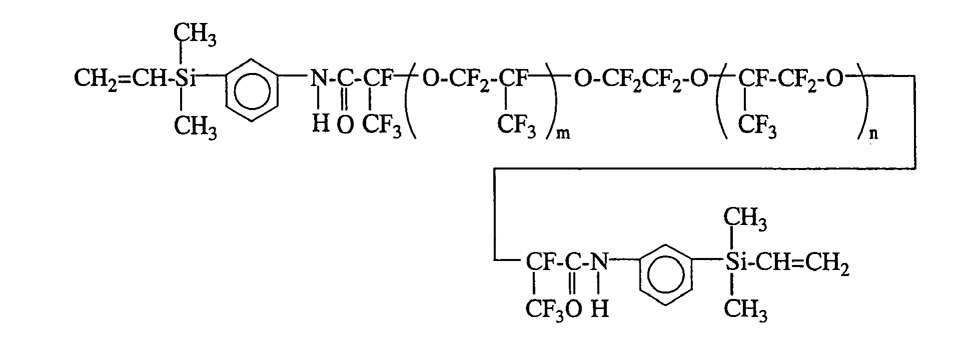 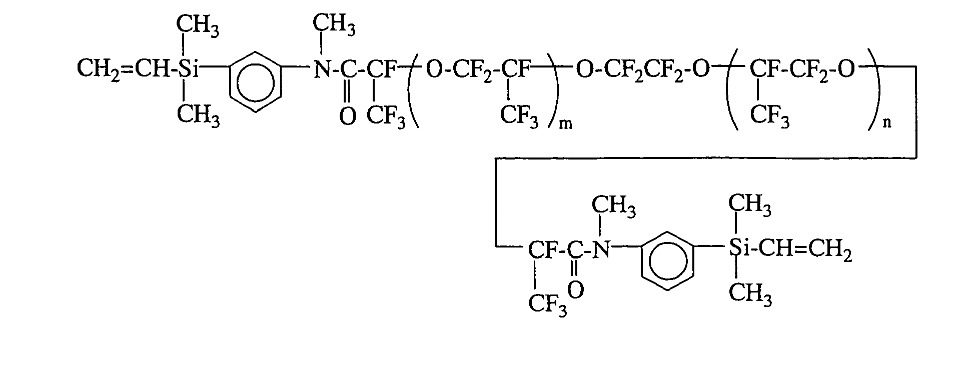 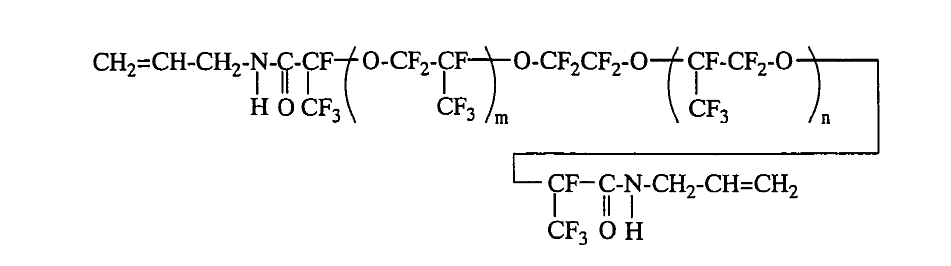 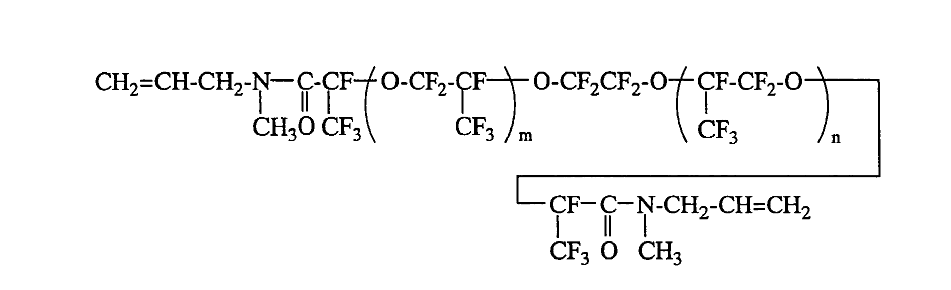 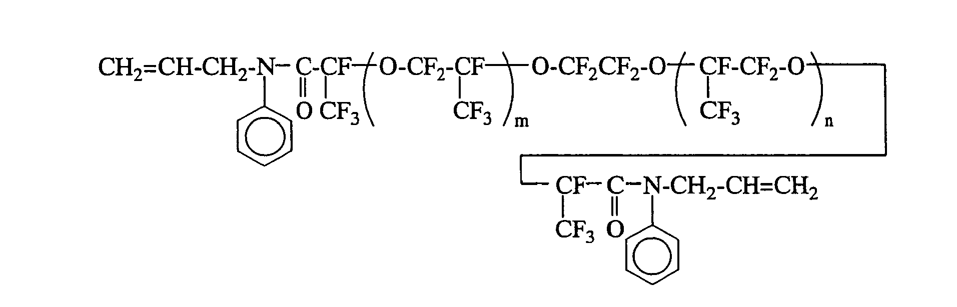 Note that each of m and n is an integer of 0 to 600, preferably 0 to 200, and the sum of m+n is 50 to 600, preferably 50 to 200.

In the practice of the invention, to modify the linear perfluoropolyether compound of formula (1) to the desired weight-average molecular weight in accordance with the intended use, the linear perfluoropolyether compound may be previously subjected to hydrosilylation with an organosilicon compound bearing two SiH radicals in a molecule by an ordinary method and under ordinary conditions. The resulting chain-extended product can be used as component (A).

### Component B

Component (B) is an organosilicon compound having at least two silicon atom-bonded hydrogen atoms (i.e., SiH radicals) in a molecule. The organosilicon compound (B) serves as a crosslinking agent and chain extender for component (A). When compatibility with and dispersion in component (A) and components (E) and (F) to be described later and uniformity after curing are taken into account, the organosilicon compound should preferably have at least one monovalent perfluoroalkyl, monovalent perfluorooxyalkyl, divalent perfluoroalkylene or divalent perfluorooxyalkylene radical in a molecule.

Suitable organosilicon compounds include, but are not limited to, well-known organosilicon compounds as described in JP-A 8-199070 (JP 2990646) and JP-A 2000-248166.

Preferred are cyclic organosilicon compounds of the general formula (8). 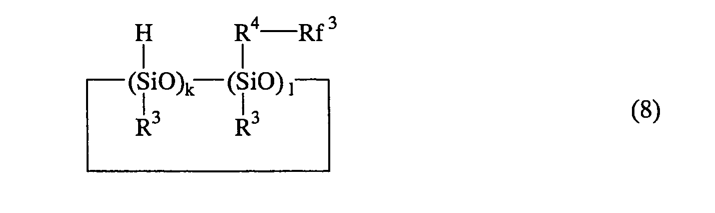 Herein Rf³ is a monovalent perfluoroalkyl or perfluoropolyether radical, R³ is a monovalent hydrocarbon radical of 1 to 20 carbon atoms, R⁴ is a divalent hydrocarbon radical of 2 to 20 carbon atoms which may contain an ether, amide, carbonyl or ester bond, k is an integer of at least 2, 1 is an integer of 1 to 6, and the sum of k+1 is 3 to 10.

Examples of monovalent perfluoroalkyl or perfluoropolyether radicals represented by Rf³ include monovalent perfluoroalkyl radicals: C_{b}F_{2b+1}- wherein b is an integer from 1 to 20, and preferably from 2 to 10 and monovalent perfluorooxyalkyl radicals: 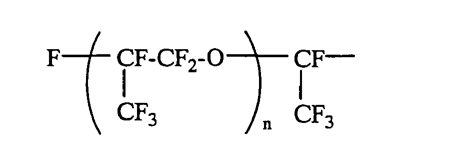 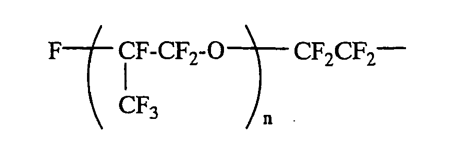 wherein n is an integer from 2 to 200, preferably 2 to 100.

R³ is a monovalent hydrocarbon radical of 1 to 20 carbon atoms, preferably 1 to 12 carbon atoms, for example, alkyl radicals such as methyl, ethyl, propyl, isopropyl, butyl, isobutyl, tert-butyl, pentyl, hexyl, octyl and decyl; cycloalkyl radicals such as cyclopentyl, cyclohexyl and cycloheptyl; alkenyl radicals such as vinyl, allyl, propenyl, isopropenyl, butenyl and hexenyl; aryl radicals such as phenyl, tolyl, xylyl and naphthyl; and aralkyl radicals such as benzyl, phenylethyl, phenylpropyl. Inter alia, those free of aliphatic unsaturation are preferred.

R⁴ is a divalent hydrocarbon radical of 2 to 20 carbon atoms which may contain an ether, amide, carbonyl or ester bond. Such divalent linking radicals include alkylene radicals, arylene radicals, and combinations thereof, in which may intervene an ether-bonding oxygen atom (-O-), amide bond (-NRCO-), carbonyl bond (-CO-), ester bond (-COO-) or a mixture thereof, with those of 2 to 12 carbon atoms being preferred (wherein R in -NRCO- is hydrogen, C₁-C₄ alkyl or phenyl). Examples of suitable divalent linking radicals are:
-CH₂CH₂-, -CH₂CH₂CH₂-, -CH₂CH₂CH₂OCH₂-, -CH₂CH₂CH₂-NH-CO-,
-CH₂CH₂CH₂-N(Ph)-CO-, -CH₂CH₂CH₂-N(CH₃)-CO-, and
-CH₂CH₂CH₂-O-CO-.
Note that Ph is phenyl.

Component (B) is generally included in an amount effective for curing components (A) and (E), specifically an amount of supplying preferably 0.2 to 2 moles, and more preferably 0.5 to 1.5 moles, of hydrosilyl (SiH) radicals per mole of total alkenyl radicals on components (A) and (E). Too little hydrosilyl (SiH) radicals may lead to an inadequate degree of crosslinking or under-cure, whereas too much may cause foaming during curing.

### Component C

Component (C) is an inorganic powder capable of chemical and/or physical adsorption of acidic gases and/or sulfur-containing gases. Suitable powders include powdered metals and powdered compounds having hydrotalcite structure, capable of chemical adsorption of acidic gases and/or sulfur-containing gases, and powdered active carbon having porosity capable of physical adsorption of acidic gases and/or sulfur-containing gases.

As used herein, "acidic gases" and "sulfur-containing gases" are generally known as corrosive gases and include gases of NOx, SOx, acetic acid, formic acid, nitric acid, sulfuric acid, sulfur, and sulfurous acid.

The powdered metal as component (C) enables to prevent or retard acidic gases or sulfur-containing gases from reaching electric/electronic parts by chemically converting acidic gases or sulfur-containing gases into oxides or sulfides. Examples of metals having such a capability include silver, copper, iron, nickel, aluminum, tin, and zinc. Of these, powdered copper is preferred for stability and cost. The shape and nature of powdered metal are not particularly limited as long as the desired effect is exerted. In consideration of the impurity content and fluidity of the composition loaded with the powdered metal, atomized metal is preferred. Suitable powdered metals are commercially available, for example, under the trade name of copper powder (flake) 3L3 by Fukuda Metal Foil Industry Co., Ltd., copper powder (atomized powder) FCC-SP-99 by Fukuda Metal Foil Industry Co., Ltd., and iron powder (atomized powder) Atomel 300M by Kobe Steel, Ltd.

The powdered compounds having hydrotalcite structure are compounds of magnesium and aluminum and have an exchangeability with anions of acidic gases or sulfur-containing gases, enabling to prevent or retard acidic gases or sulfur-containing gases from reaching electric/electronic parts.

The powdered compounds having hydrotalcite structure which can be used herein may be prior art well-known ones. Examples are given in a number of patents including JP 2501820, JP 2519277, JP 2712898, JP 3167853, JP-B 06-051826, JP-A 09-118810, JP-A 10-158360, JP-A 11-240937, JP-A 11-310766, JP-A 2000-159520, JP-A 2000-230110, and JP-A 2002-080566 as the ion trapping agent added to semiconductor encapsulating materials for improving reliable moisture resistance and temperature capability. Any of the compounds described in these patents may be used.

In particular, compounds of the general formula (9) are useful:

MgₓAl_{y}(OH)_{2x+3y-2z}(CO₃)_{z}·αH₂O (9)

wherein x, y and z are numbers satisfying the range: 0 < y/x ≤ 1 and 0 ≤ z/y < 1.5, and α is an integer. Examples of the powdered compounds having hydrotalcite structure include
1.25Mg(OH)₂·Al(OH)₃·CO₃·zCOH₃·O,
Mg₆Al₂(OH)₁₆CO₃·4H₂O, and
Mg_{4.5}Al₂(OH)₁₃CO₃·3.5H₂O.

Hydrotalcite has an anion exchangeability. When it is in contact with HCl gas, for example, chemical adsorption occurs according to the reaction scheme below.

Mg₆Al₂(OH)₁₆CO₃·4H₂O + 2HCl → Mg₆Al₂(OH)₁₃Cl₂·nH₂O + H₂O + CO₂

The powdered compounds having hydrotalcite structure are commercially available, for example, under the trade name of Kyoward 500, Kyoward 1000, and DHT-4A-2 by Kyowa Chemical Industry Co., Ltd.

A further embodiment of the inorganic powder capable of physical adsorption of acidic gases and/or sulfur-containing gases is powdered active carbon having porosity. It is capable of selective adsorption of acidic gases or sulfur-containing gases within the porous structure, enabling to prevent or retard acidic gases or sulfur-containing gases from reaching electric/electronic parts. Examples of the powdered active carbon include steam-activated carbon produced from wooden raw materials by steam activation and zinc chloride-activated carbon produced by chemical activation and purification. The powdered active carbon with porosity is commercially available, for example, under the trade name of activated carbon Shirasagi grades A, C, M and P by Nippon Enviro-Chemicals, Ltd.

The amount of the inorganic powder (C) added should be enough to achieve the desired effect of preventing or retarding acidic gases or sulfur-containing gases from reaching electric/electronic parts and is typically 0.1 to 50 parts by weight per 100 parts by weight of component (A) or components (A) and (E) combined. For the fluidity of the composition and the volume resistivity of the cured composition, the preferred amount of the inorganic powder is 0.3 to 30 parts by weight, even more preferably 0.5 to 20 parts by weight.

If the cured perfluoropolyether composition is electroconductive or has a volume resistivity of less than 1×10⁹ Ω-cm, the composition is unacceptable for use with electric/electronic parts. It is necessary to maintain a certain volume resistivity. Thus the type and amount of the inorganic powder should be selected so that the cured perfluoropolyether composition has a volume resistivity of equal to or more than 1×10⁹ Ω-cm, especially equal to or more than 1×10¹⁰ Ω-cm.

### Component D

Component (D) is a hydrosilylation catalyst which promotes addition reaction between alkenyl radicals in components (A) and (E) and hydrosilyl radicals in component (B). The hydrosilylation catalysts are typically noble metal compounds which are expensive. Platinum and platinum compounds are thus used because they are readily available.

Exemplary platinum compounds include chloroplatinic acid, complexes of chloroplatinic acid with olefins such as ethylene, complexes of chloroplatinic acid with alcohols and vinylsiloxanes, and metallic platinum supported on silica, alumina or carbon, though are not limited thereto. Known platinum group metal compounds other than the platinum compounds include rhodium, ruthenium, iridium, and palladium compounds, for example, RhCl(PPh₃)₃, RhCl(CO)(PPh₃)₂, Ru₃(CO)₁₂, IrCl(CO)(PPh₃)₂, and Pd(PPh₃)₄ wherein Ph denotes phenyl.

The amount of the hydrosilylation catalyst used may be a catalytic amount, and preferably an amount to give 0.1 to 100 ppm of platinum group metal based on the total weight of components (A), (B) and (E).

### Component E

Component (E) is a polyfluoromonoalkenyl compound containing one alkenyl radical per molecule and having a perfluoropolyether structure in its backbone. It is preferably a polyfluoromonoalkenyl compound having the general formula (2):

Rf¹-(X')ₚ-CH=CH₂ (2)

wherein X' and p are as defined above, Rf¹ is a radical of the general formula:

F-[CF(CF₃)CF₂O]_{w}-CF(CF₃)-

wherein w is an integer of 1 to 500, and preferably 2 to 200.

Illustrative examples of the polyfluoromonoalkenyl compound having formula (2) are given below. 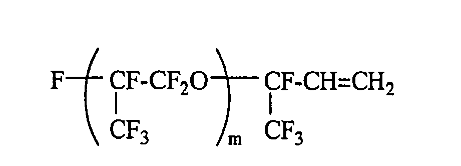 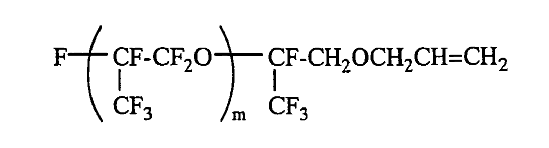 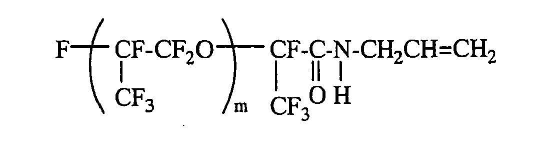 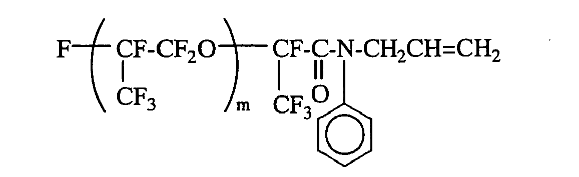 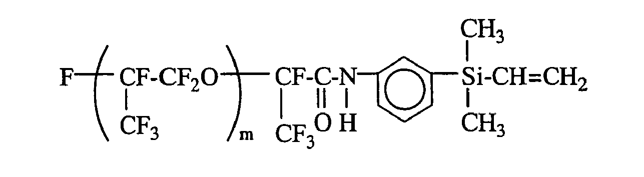 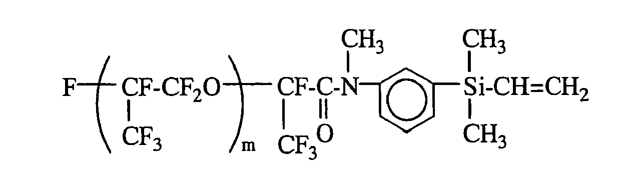 Herein m is an integer of 1 to 200, and preferably 2 to 100.

In the curable perfluoropolyether gel composition, an appropriate amount of component (E) or polyfluoromonoalkenyl compound having formula (2) compounded is 75 to 35 parts by weight relative to 25 to 65 parts by weight of component (A) or linear perfluoropolyether dialkenyl compound, provided that components (A) and (E) sum to 100 parts by weight.

### Component F

Regardless of whether it is a rubber or gel composition, the perfluoropolyether composition of the invention may further comprise (F) a nonfunctional fluoropolymer having a perfluoropolyether structure comprising recurring units -CₐF₂ₐO- wherein "a" is as defined above, but free of alkenyl radicals. This nonfunctional fluoropolymer is most preferably linear.

The linear perfluoropolyether compound, when compounded as component (F), serves to improve chemical resistance, solvent resistance and low-temperature properties without detracting from physical properties. Particularly when it is compounded in perfluoropolyether rubber and gel compositions, it is effective for imparting improved low-temperature properties, typically lowering the glass transition temperature.

Component (F) is preferably at least one linear perfluoropolyether compound selected from the group consisting of compounds having the general formula (3):

A-O-(CF₂CF₂CF₂O)_{d}-A (3)

wherein A is a radical of CₑF₂ₑ₊₁- wherein e is 1 to 3, and d is an integer of 1 to 500, preferably 2 to 200, and compounds having the general formula (4):

A-O-(CF₂O)_{f}(CF₂CF₂O)ₕ-A (4)

wherein A is as defined above, and f and h each are an integer of 1 to 300, preferably 1 to 100.

Illustrative examples of component (F) are:

CF₃O-(CF₂CF₂CF₂O)_{n'}-CF₂CF₃
and
CF₃-[(OCF₂CF₂)_{n'}(OCF₂)_{m'}]-O-CF₃

wherein m' is an integer of 1 to 200, n' is an integer of 1 to 200, and m'+n' is 1 to 200.

An appropriate amount of component (F) compounded varies whether the perfluoropolyether composition is a rubber or gel composition. In the perfluoropolyether gel composition, the preferred amount of component (F) is 20 to 100 parts by weight per 100 parts by weight of components (A) and (E) combined, i.e., polyfluorodialkenyl compound plus polyfluoromonoalkenyl compound. In the perfluoropolyether rubber composition, the preferred amount of component (F) is 10 to 50 parts by weight per 100 parts by weight of component (A). Component (F) may be one or a mixture of two or more of suitable compounds.

### Other components

In addition to components (A) to (F) described above, the compositions of the invention may further comprise various additives. Suitable hydrosilylation catalyst regulators include acetylenic alcohols such as 1-ethynyl-1-hydroxycyclohexane, 3-methyl-1-butyn-3-ol, 3,5-dimethyl-1-hexyn-3-ol, 3-methyl-1-penten-3-ol and phenylbutynol; 3-methyl-3-penten-1-yne and 3,5-dimethyl-3-hexen-1-yne; polymethylvinylsiloxane cyclic compounds; and organophosphorus compounds. The addition of such regulators keeps appropriate cure reactivity and shelf stability.

Suitable inorganic fillers include fumed silica, fused silica, crystalline silica, iron oxide, zinc oxide, titanium oxide, calcium carbonate, magnesium carbonate, zinc carbonate, and carbon black. The addition of such inorganic fillers adjusts the hardness or mechanical strength of cured products of the compositions. Hollow inorganic fillers or spherical rubbery fillers are also useful.

To impart adhesion, any of well-known tackifiers having epoxy, alkoxy or similar radicals may be added. These additives may be used in any desired amounts as long as they do not interfere with properties of the compositions or properties of the cured products.

### Compositions and cured products

The curable perfluoropolyether rubber composition can be prepared by combining 100 parts by weight of component (A) with an amount of component (B) to provide 0.2 to 2.0 moles of hydrosilyl radicals per mole of total alkenyl radicals in component (A), 0.1 to 50 parts by weight of component (C), and an amount of component (D) to provide 0.1 to 100 ppm of platinum relative to the total weight of components (A) and (B). To the mix, 10 to 50 parts by weight of component (F) may be added if desired for reducing the glass transition temperature.

The curable perfluoropolyether rubber composition may be cured simply by heating at a temperature of 60 to 150°C for about 30 to about 180 minutes. The rubber thus cured is typically a rubber material having a hardness of 10 to 80 according to JIS K6249 (Durometer A hardness) and a glass transition temperature of up to -50°C.

The curable perfluoropolyether rubber composition is used as the adhesive for automotive electric/electronic packages as mentioned above. The composition may be used as the adhesive by coating or otherwise applying the composition onto a substrate and then curing. The curing is readily achieved by heating at a temperature of 60 to 150°C for about 30 to about 180 minutes.

The curable perfluoropolyether gel composition can be prepared by combining 25 to 65 parts by weight of component (A) with 75 to 35 parts by weight of component (E), with the proviso that the sum of components (A) and (E) is 100 parts by weight, an amount of component (B) to provide 0.2 to 2.0 moles of hydrosilyl radicals per mole of total alkenyl radicals in components (A) and (E), 0.1 to 50 parts by weight of component (C), and an amount of component (D) to provide 0.1 to 100 ppm of platinum relative to the total weight of components (A), (B) and (E). To the mix, 20 to 100 parts by weight of component (F) may be added if desired for reducing the glass transition temperature.

The curable perfluoropolyether gel composition may be cured simply by heating at a temperature of 60 to 150°C for about 30 to about 180 minutes. The gel thus cured is typically a gel material having a penetration of 10 to 150 according to the consistency test (using a 1/4 cone) of JIS K2220 or ASTM D-1403 and a glass transition temperature of up to -50°C.

The curable perfluoropolyether gel composition is used as the encapsulant for automotive electric/electronic packages as mentioned above.

### EXAMPLE

Examples are given below by way of illustration and not by way of limitation. Note that all parts (pbw) and % are by weight.

### Preparation Examples 1 and 2

Using the ingredients identified below, perfluoropolyether rubber and gel compositions were prepared as formulated in Table 1.

The rubber and gel compositions were cured under conditions of 150°C and 1 hour, following which the hardness of the cured products was measured. The results are also shown in Table 1.

### Ingredients

(a) Inorganic powder
   (a-1) copper powder (flake), 3L3 by Fukuda Metal Foil Industry Co., Ltd.
   (a-2) synthetic hydrotalcite, Kyoward 500 by Kyowa Chemical Industry Co., Ltd.
(b) Perfluoropolyether oil 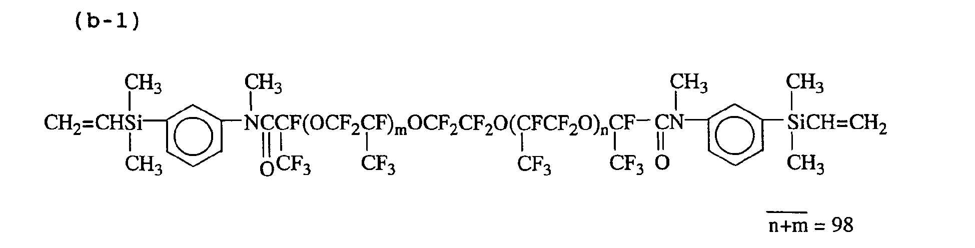 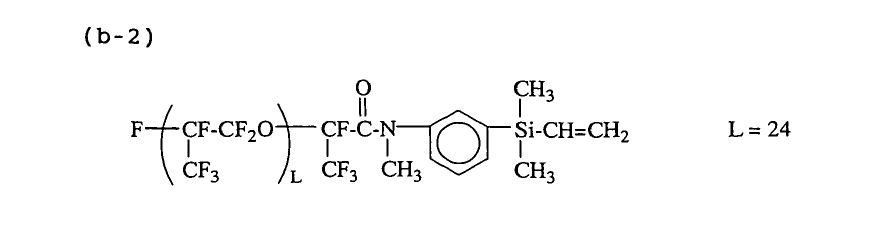
(b-3)

   CF₃O-(CF₂CF₂CF₂O)ₑ-C₂F₅ e = 27
(c) Hydrosiloxane 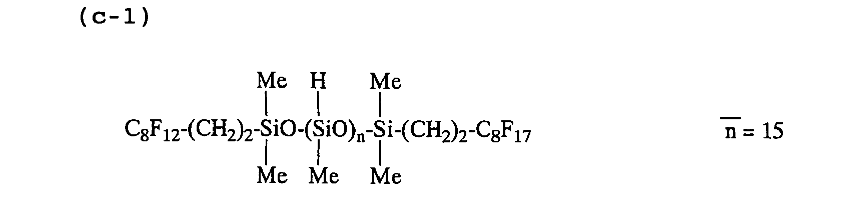 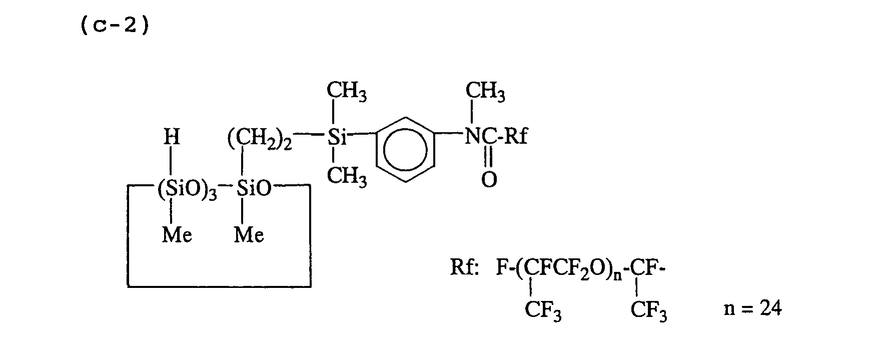
(d) Catalyst, toluene solution of platinum-divinyltetramethyldisiloxane complex (platinum content 0.5%)
(e) Curing regulator, 50% toluene solution of ethynyl cyclohexanol

**Table 1**

| Ingredients (pbw) | | Composition | |
|---|---|---|---|
| | | 1 | 2 |
| a-1 | Cu powder (flake) | 5 | |
| a-2 | Kyoward 500 | | 2 |
| b-1 | Perfluoropolyether 1 | 100 | 55 |
| b-2 | Perfluoropolyether 2 | | 20 |
| b-3 | Perfluoropolyether 3 | | 25 |
| c-1 | Hydrosiloxane 1 | 2 | |
| c-2 | Hydrosiloxane 2 | | 20 |
| d | Pt compound | 0.2 | 0.12 |
| e | Curing regulator | 0.3 | 0.15 |
| JIS K6249 Hardness (Durometer A) | | 38 | |
| JIS K2220 Hardness (penetration) | | | 76 |

### Example 1

The perfluoropolyether rubber composition (Composition 1) prepared above was used as an adhesive to provide bonds 4 between base 2 and case 3, between case 3 and lid 5, and between base 2 and substrate 6 in FIG. 1, completing an automotive electric/electronic package as shown in FIG. 1. Note that the circuit 1 on substrate 6 which is received within case 3 and bonded to base 2 is formed using a silver paste.

This package was held in an atmosphere of 5% hydrogen sulfide (H₂S) for one month. Thereafter, with lid 5 removed, the state of the circuit 1 was observed, finding no corrosion on the circuit 1.

### Example 2

The perfluoropolyether rubber composition (Composition 1) prepared above was used as an adhesive to provide bonds 4 between base 2 and case 3 and between base 2 and substrate 6 in FIG. 2 and also as an encapsulant to encapsulate at 8 the silver circuit 1 on substrate 6, completing an automotive electric/electronic package as shown in FIG. 2.

This package was held in an atmosphere of 10% NOx (a mixture of NO, NO₂ and N₂O) for one month. Thereafter, the encapsulant was removed, and the state of the circuit 1 was observed, finding no corrosion on the circuit 1.

## Claims

1. An automotive electric/electronic package comprising an electronic component capable of functioning on application of electricity (such as a circuit board having electronic chips mounted thereon), a case for receiving the electronic component therein and having an open top, and a lid covering the open top of the case, wherein
said case and said lid are joined together with a fluorochemical adhesive capable of chemically and/or physically adsorbing a corrosive gas.

2. An automotive electric/electronic package comprising an electronic component capable of functioning on application of electricity (such as a circuit board having electronic chips mounted thereon), a base to which the electronic component is fixedly secured, a case surrounding the electronic component and having an open top, and a lid covering the open top of the case, wherein
said case and said base and/or said case and said lid are joined together with a fluorochemical adhesive capable of chemically and/or physically adsorbing a corrosive gas.

3. An automotive electric/electronic package comprising an electronic component capable of functioning on application of electricity (such as a circuit board having electronic chips mounted thereon), a base to which the electronic component is fixedly secured, a case surrounding the electronic component and having an open top, and optionally, a lid covering the open top of the case, wherein
said electronic component is encapsulated with a fluorochemical encapsulant capable of chemically and/or physically adsorbing a corrosive gas, and
optionally, said case and said base and/or said case and said lid are joined together with a fluorochemical adhesive capable of chemically and/or physically adsorbing a corrosive gas.

4. The package of any one of claims 1 to 3 wherein a terminal is secured to said case or said base containing the electronic component for providing an electrical connection between the electronic component and the exterior, and
optionally, any gap between the terminal and the case, lid or base is filled with a sealant which is a fluorochemical encapsulant capable of chemically and/or physically adsorbing a corrosive gas.

5. The package of any one of claims 1 to 4 wherein the fluorochemical adhesive or encapsulant is capable of chemically and/or physically adsorbing a corrosive gas which is selected from the group consisting of sulfur gas, sulfur base compound gases, nitrogen oxide gases, COx gases, chlorine compound gases, and mixtures thereof.

6. The package of claim 5 wherein said fluorochemical adhesive is a curable perfluoropolyether rubber composition comprising
(A) 100 parts by weight of a linear perfluoropolyether compound containing at least two alkenyl radicals per molecule and having in its backbone a perfluoropolyether structure containing recurring units -CₐF₂ₐO- wherein a is an integer of 1 to 6,
(B) a curing amount of an organosilicon compound containing at least two silicon-bonded hydrogen atoms per molecule,
(C) 0.1 to 50 parts by weight of an inorganic powder capable of chemically and/or physically adsorbing an acidic gas and/or sulfur-containing gas, and
(D) a catalytic amount of a hydrosilylation catalyst.

7. The package of claim 5 wherein said fluorochemical encapsulant is a curable perfluoropolyether gel composition comprising
(A) 25 to 65 parts by weight of a linear perfluoropolyether compound containing at least two alkenyl radicals per molecule and having in its backbone a perfluoropolyether structure containing recurring units -CₐF₂ₐO- wherein a is an integer of 1 to 6,
(B) a curing amount of an organosilicon compound containing at least two silicon-bonded hydrogen atoms per molecule,
(C) 0.1 to 50 parts by weight of an inorganic powder capable of chemically and/or physically adsorbing an acidic gas and/or sulfur-containing gas,
(D) a catalytic amount of a hydrosilylation catalyst, and
(E) 75 to 35 parts by weight of a polyfluoromonoalkenyl compound containing one alkenyl radical per molecule and having a perfluoropolyether structure in its backbone, with the proviso that the total amount of components (A) and (E) is 100 parts by weight.

8. The package of claim 6 or 7 wherein component (C) in the perfluoropolyether composition is a metallic powder.

9. The package of claim 8 wherein component (C) in the perfluoropolyether composition is copper.

10. The package of claim 6 or 7 wherein component (C) in the perfluoropolyether composition is a powdered active carbon having porosity.

11. The package of claim 6 or 7 wherein component (C) in the perfluoropolyether composition is a powdered compound having hydrotalcite structure.

12. The package of any one of claims 6 to 11 wherein component (A) in the perfluoropolyether composition is a linear perfluoropolyether compound having the general formula (1): 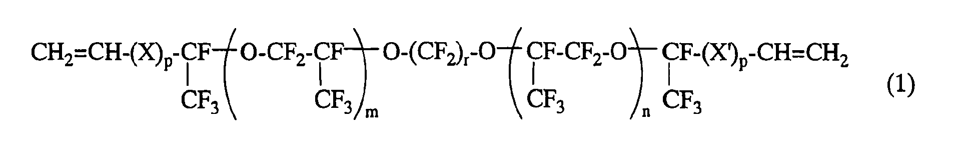 wherein X is -CH₂-, -CH₂O-, -CH₂OCH₂- or -Y-NR¹-CO-, wherein Y is -CH₂- or a dimethylphenylsilylene radical of the structural formula (Z): 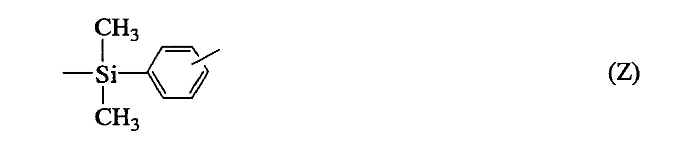 (inclusive of o-, m- and p-positions) and R¹ is hydrogen, methyl, phenyl or allyl radical,
X' is -CH₂-, -OCH₂-, -CH₂OCH₂- or -CO-NR²-Y'-, wherein Y' is -CH₂- or a dimethylphenylsilylene radical of the structural formula (Z'): 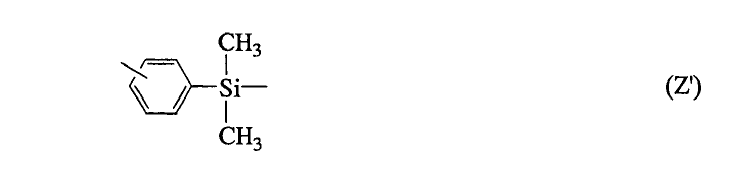 (inclusive of o-, m- and p-positions) and R² is hydrogen, methyl, phenyl or allyl radical,
p is independently 0 or 1, r is an integer from 2 to 6, m and n each are an integer of 0 to 600, and the sum of m+n is 50 to 600.

13. The package of any one of claims 7 to 12 wherein component (E) in the perfluoropolyether composition is a polyfluoromonoalkenyl compound having the general formula (2):
Rf¹-(X')ₚ-CH=CH₂ (2)
wherein X' and p are as defined above, and Rf¹ has the general formula:
F-[CF(CF₃)CF₂O]_{w}-CF(CF₃)-
wherein w is an integer of 1 to 500.

14. The package of any one of claims 7 to 13 wherein the perfluoropolyether composition further comprises (F) at least one linear polyfluoro compound selected from compounds having the general formulae (3) and (4):
A-O-(CF₂CF₂CF₂O)_{d}-A (3)
A-O-(CF₂O)_{f}(CF₂CF₂O)ₕ-A (4)
wherein A is a radical of CₑF₂ₑ₊₁- wherein e is an integer of 1 to 3, d is an integer of 1 to 500, f and h each are an integer of 1 to 300.
